(19) Europäisches Patentamt
European Patent Office
Office européen des brevets

(11) **EP 2 200 091 B1**

(12) **EUROPEAN PATENT SPECIFICATION**

(45) Date of publication and mention
of the grant of the patent:
**16.11.2016 Bulletin 2016/46**

(51) Int Cl.:
*H01L 31/04* (2006.01)     *H01B 1/16* (2006.01)
*C03C 3/064* (2006.01)     *C03C 8/18* (2006.01)
*H01L 31/0224* (2006.01)    *H05K 1/09* (2006.01)

(21) Application number: **08834130.0**

(22) Date of filing: **18.08.2008**

(86) International application number:
**PCT/JP2008/064705**

(87) International publication number:
**WO 2009/041182 (02.04.2009 Gazette 2009/14)**

(54) **AG ELECTRODE PASTE, SOLAR BATTERY CELL, AND PROCESS FOR PRODUCING THE SOLAR BATTERY CELL**

AG-ELEKTRODENPASTE, SOLARBATTERIEZELLE UND PROZESS ZUR HERSTELLUNG DER SOLARBATTERIEZELLE

PÂTE D'ÉLECTRODE À BASE DE AG, CELLULE DE BATTERIE SOLAIRE ET PROCÉDÉ DE FABRICATION DE LA CELLULE DE BATTERIE SOLAIRE

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **27.09.2007 JP 2007251609**

(43) Date of publication of application:
**23.06.2010 Bulletin 2010/25**

(73) Proprietor: **Shin-Etsu Chemical Co., Ltd.
Tokyo 100-0004 (JP)**

(72) Inventor: **KAWAGUCHI, Yoshihiro
Nagaokakyo-shi
Kyoto 617-8555 (JP)**

(74) Representative: **Laufhütte, Dieter et al
Lorenz Seidler Gossel
Rechtsanwälte Patentanwälte
Partnerschaft mbB
Widenmayerstraße 23
80538 München (DE)**

(56) References cited:
EP-A2- 1 713 092       EP-A2- 1 713 094
WO-A1-2007/102287      WO-A1-2007/102287
JP-A- 11 329 072        JP-A- 2002 270 035
JP-A- 2005 353 691      JP-A- 2006 313 744
JP-A- 2006 339 342      JP-U- 61 186 255

**Description**

TECHNICAL FIELD

The invention of the present application relates to Ag electrode paste, a solar battery cell having a light-reception-surface-side electrode formed with the same, and a method of manufacturing a solar battery cell including the step of forming a light-reception-surface-side electrode with the Ag electrode paste.

BACKGROUND ART

A method of manufacturing a solar battery cell, in which a PN junction is formed on a semiconductor substrate, thereafter a comb-shaped finger electrode and a bus bar electrode connected to the finger electrode are formed on at least one main surface of the semiconductor substrate, and the bus bar electrode having a two-layered structure is formed by printing conductive paste twice followed by firing, is disclosed as a conventional method of manufacturing a solar battery cell (see Figs. 1 to 4 of Patent Document 1).

According to this method of manufacturing a solar battery cell, conversion efficiency of a solar battery cell is improved by ensuring ohmic contact between an Ag electrode and an Si substrate through the bus bar electrode in the first layer out of the bus bar electrodes (in the example, the Ag electrode) stacked in two layers on a surface of the solar battery cell and by lowering an electrode line resistance in the bus bar electrode in the second layer.

In addition, regarding Ag/Al electrode paste for a crystalline silicon solar battery cell, electrode paste including lead-free glass frits composed as follows has been proposed (Patent Document 2):

0.5 to 35 wt % $SiO_2$;

0 to 5 wt % $Al_2O_3$;

1 to 15 wt % $B_2O_3$:

0 to 15 wt % ZnO; and

55 to 90 wt % $Bi_2O_3$.

In the case of a solar battery cell having a two-layered bus bar electrode (a light-reception-surface-side electrode) implemented by Ag electrodes as in Patent Document 1 above, glass frits contained in the Ag electrode paste for forming the bus bar electrode in the upper layer flows to the surface of the bus bar electrode on the upper layer side during firing of the electrode, which may lead to lower solderability, for example, in soldering a lead or the like to the bus bar electrode on the upper layer side.

Meanwhile, if glass frits contained in the Ag electrode paste for forming the bus bar electrode on the upper layer side excessively flow to the bus bar electrode on the lower layer side, ohmic contact between the bus bar electrode on the lower layer side and the Si substrate is impeded and conversion efficiency of the solar battery cell may be lowered.

Further, if sintering of the bus bar electrode on the upper layer side is completed before a gas generated from the bus bar electrode (the Ag electrode) on the lower layer side (a decomposition gas, a combustion gas or the like of a binder) during firing of the Ag electrode paste completely escapes, the gas described above disadvantageously causes blister.

The electrode paste in Patent Document 2 relates to an Ag/Al electrode, and this document does not provide information useful for lead-free glass frits used for the Ag electrode paste to be used in the present application. Namely, this document does not actually suggest a method of obtaining a solar battery cell having better characteristics in forming an Ag electrode as a light-reception-surface-side electrode of the solar battery cell.

Patent Document 3 discloses an electrically conductive paste for a light-receiving surface electrode of a solar cell. The paste comprises Ag powder, an organic vehicle and a lead-free glass frit. The glass frit comprises $SiO_2$, $Bi_2O_3$ (<20 mol%), $Al_2O_3$ (<15 mol%), $TiO_2$ (<10 mol%) and CuO (<15 mol%) with a $B_2O_3/SiO_2$ ratio of 0.3 or less on a molar basis.

Patent Document 1: Japanese Patent Laying-Open No. 2006-339342

Patent Document 2: Japanese Patent Laying-Open No. 2006-313744

Patent Document 3: International Patent Application WO 2007/102287 A1

DISCLOSURE OF THE INVENTION

PROBLEMS TO BE SOLVED BY THE INVENTION

The invention of the present application was made in view of the circumstances above, and an object thereof is to provide Ag electrode paste for forming a light-reception-surface-side electrode, with which a solar battery cell having a light-reception-surface-side electrode low in line resistance and achieving high conversion efficiency can be obtained, a solar battery cell having good characteristics manufactured therewith, and a method of manufacturing the same, and further to provide Ag electrode paste, with which a line resistance of the light-reception-surface-side electrode can be lowered even though the light-reception-surface-side electrode has a two-layered structure and a solar battery cell achieving high conversion efficiency can be obtained without increasing an interface resistance between an Ag electrode (a first electrode) on a lower layer side and a semiconductor substrate, a solar battery cell having good characteristics manufactured therewith, and a method of manufacturing the same.

MEANS FOR SOLVING THE PROBLEMS

In order to solve the problem above, Ag electrode paste according to the invention of the present application (claim 1) is Ag electrode paste used for forming a light-reception-surface-side electrode of a solar battery cell including a semiconductor substrate, the light-reception-surface-side electrode arranged on one main surface functioning as a light reception surface out of a pair of main surfaces of the semiconductor substrate opposed to each other, and a back electrode arranged on the other main surface, and the Ag electrode paste contains:

(a) Ag particles;

(b) an organic vehicle; and

(c) lead-free glass frits containing 13 to 17 weight % $SiO_2$, 0 to 6 weight % $B_2O_3$,

65 to 75 weight % $Bi_2O_3$, 1 to 5 weight % $Al_2O_3$, 1 to 3 weight % $TiO_2$, and 0.5 to 2 weight % CuO, wherein when the light-reception-surface-side electrode includes a first electrode obtained by firing first Ag electrode paste and a second electrode obtained by firing second Ag electrode paste formed on the first electrode, the Ag electrode paste is used as the second Ag electrode paste.

Alternatively, a solar battery cell according to the present invention (claim 2) is a solar battery cell including a semiconductor substrate, a light-reception-surface-side electrode arranged on one main surface functioning as a light reception surface out of a pair of main surfaces of the semiconductor substrate opposed to each other, and a back electrode arranged on the other main surface, the light-reception-surface-side electrode includes a first electrode obtained by firing first Ag electrode paste and a second electrode obtained by firing second Ag electrode paste formed on the first electrode, and the Ag electrode paste according to claim 1 is used as the second Ag electrode paste.

In addition, a method of manufacturing a solar battery cell according to the present invention (claim 3) is a method of manufacturing a solar battery cell including a semiconductor substrate, a light-reception-surface-side electrode arranged on one main surface functioning as a light reception surface out of a pair of main surfaces of the semiconductor substrate opposed to each other, and a back electrode arranged on the other main surface and having such a structure that the light-reception-surface-side electrode includes a first electrode obtained by firing first Ag electrode paste and a second electrode obtained by firing second Ag electrode paste formed on the first electrode, and the method includes the steps of: forming an Ag electrode paste pattern for the first electrode by applying the first Ag electrode paste in a prescribed pattern onto the semiconductor substrate; forming an Ag electrode paste pattern for the second electrode by applying the Ag electrode paste according to claim 1 in a prescribed pattern onto the Ag electrode paste pattern for the first electrode; and simultaneously firing the Ag electrode paste pattern for the first electrode and the Ag electrode paste pattern for the second electrode.

EFFECTS OF THE INVENTION

The Ag electrode paste according to the invention of the present application (claim 1) is the Ag electrode paste used for forming a light-reception-surface-side electrode of a solar battery cell, that contains Ag particles, an organic vehicle, and lead-free glass frits. The lead-free glass frits contain 13 to 17 weight % $SiO_2$, 0 to 6 weight % $B_2O_3$, 65 to 75 weight % $Bi_2O_3$, 1 to 5 weight % $Al_2O_3$, 1 to 3 weight % $TiO_2$, and 0.5 to 2 weight % CuO.

As the lead-free glass frits contain a proper amount of CuO, start of sintering of the electrode is delayed. In addition, as the lead-free glass frits contain a proper amount of $Al_2O_3$ and $TiO_2$ in glass, crystallization is less likely and moderate flowability is ensured so that the glass moderately flows to an interface of the semiconductor substrate in the firing step. The glass therefore can be prevented from sintering in such a state that the glass floats and remains at the surface of the Ag electrode and good solderability can be ensured. Moreover, the Ag electrode paste according to the present invention containing the lead-free glass frits achieves a low resistance of a sintered object formed by firing, and it can form an electrode low in line resistance as the light-reception-surface-side electrode of the solar battery cell. Further, sintering is not completed before a binder decomposition gas or the like completely escapes, so that occurrence of blister can be prevented.

In addition, since the light-reception-surface-side electrode includes the first electrode obtained by firing the first Ag electrode paste and the second electrode obtained by firing the second Ag electrode paste formed on the first electrode, when the Ag electrode paste is used as the second Ag electrode paste, lead-free glass frits used for the Ag electrode paste according to the present invention do not impede ohmic contact between the first electrode which is the electrode in the first layer and the semiconductor substrate even though it flows into the first electrode which is the electrode in the first layer in the firing step. Good ohmic contact can thus be ensured between the first electrode and the semiconductor substrate and the solar battery cell achieving high conversion efficiency can be obtained.

Therefore, by using the Ag electrode paste according to the present invention as the Ag electrode paste for forming the second electrode, a line resistance of the electrode can be lowered and an interface resistance between the first electrode (the electrode in the first layer) and the semiconductor substrate is not increased. The solar battery cell achieving high conversion efficiency can thus be obtained. Further, occurrence of such a defect as blister caused by sintering of the second electrode before complete escape of a decomposition gas, a combustion gas or the like of a binder for the first electrode can be prevented.

Alternatively, in the solar battery cell according to the present invention, in an example where the light-reception-surface-side electrode includes the first electrode obtained by firing the first Ag electrode paste and the second electrode obtained by firing the second Ag electrode paste formed on the first electrode, the Ag electrode paste described above according to the present invention is used as the second Ag electrode paste. A highly reliable solar battery cell having a low line resistance of the electrode and a low interface resistance between the first electrode (the electrode in the first layer) and the semiconductor substrate, achieving high conversion efficiency, and free from such a defect as blister can thus be provided.

Further, in the method of manufacturing a solar battery cell according to the present invention (claim 3), the Ag electrode paste pattern for the first electrode is formed by applying the first Ag electrode paste in a prescribed pattern onto the semiconductor substrate, the Ag electrode paste pattern for the second electrode is formed by applying the Ag electrode paste according to claim 1 in a prescribed pattern onto the Ag electrode paste pattern for the first electrode, and thereafter the Ag electrode paste pattern for the first electrode and the Ag electrode paste pattern for the second electrode are simultaneously fired. A highly reliable solar battery cell having a low line resistance of the electrode and a low interface resistance between the first electrode and the semiconductor substrate, achieving high conversion efficiency, and free from such a defect as blister can thus efficiently be manufactured.

BRIEF DESCRIPTION OF THE DRAWINGS

Fig. 1 is a plan view of a solar battery cell having a light-reception-surface-side electrode formed with Ag electrode paste according to the present invention.
Fig. 2 is an enlarged view of a cross-section of the solar battery cell in Fig. 1.
Fig. 3 is a diagram showing a structure of a semiconductor substrate for evaluating a contact resistance, fabricated in an example of the present invention.

DESCRIPTION OF THE REFERENCE SIGNS

1 semiconductor substrate
2 n-type impurity layer
3 anti-reflection coating
10 light-reception-surface-side electrode
11 first electrode
12 second electrode
20 back electrode
L distance between electrodes

Z length of electrode

BEST MODES FOR CARRYING OUT THE INVENTION

[Ag Electrode Paste According to the Present Invention]

The Ag electrode paste according to the present invention is prepared by blending Ag particles, lead-free glass frits, and an organic vehicle.

Ag particles (Ag powders) used in the Ag electrode paste according to the present invention are not particularly restricted, and Ag particles having various properties such as scale-like powders, spherical powders, powders in irregular shape, or mixture thereof may be employed.

The Ag particle has an average particle size (D50) preferably not greater than 20 $\mu$m and particularly preferably in a range from 0.1 to 10 $\mu$m.

When the Ag particle has an average particle size exceeding 20 $\mu$m, printability of the Ag electrode paste becomes poor, which is not preferred.

It is noted that various Ag particles, for example, Ag particles having various properties such as scale-like powders, spherical powders or powders in irregular shape, or Ag particles different in particle size within the range above, may be employed, alone or in combination of two or more of them.

A ratio of blended Ag particles is preferably in a range from 70 to 92 weight % with respect to the whole Ag electrode paste in a state of paste before firing. When the ratio of Ag particles is lower than 70 weight %, a ratio of a conductive component is excessively low and firing density of the electrode is lowered. When the ratio of Ag particles exceeds 92 weight %, viscosity is significantly high and printability or ease in an application operation becomes poor.

An organic vehicle (for example, a vehicle obtained by dissolving a binder resin in a solvent) used for the Ag electrode paste according to the present invention is not particularly restricted, and various thermally decomposable materials that have conventionally been used as a firing-type resin composition can be employed. Examples thereof include cellulosic derivatives such as methylcellulose, ethyl cellulose and carboxymethyl cellulose, polyvinyl alcohols, polyvinyl pyrrolidones, acrylic resins, vinyl acetate-acrylic ester copolymers, butyral resin derivatives such as polyvinyl butyral, alkyd resins such as phenol-modified alkyd resin and castor oil fatty acid modified alkyd resin. These resins can be used alone or in combination of two or more types.

Various solvents capable of dissolving the binder resin above can normally be used as the solvent for the organic vehicle (the binder resin) above. In the Ag electrode paste according to the present invention, an organic vehicle obtained by dissolving a binder resin in advance in a solvent is preferably used in a manner mixed with Ag particles and lead-free glass frits.

Examples of the solvent include dioxane, hexane, toluene, ethyl cellosolve, cyclohexanone, butyl cellosolve, butyl cellosolve acetate, butyl carbitol acetate, diethylene glycol diethyl ether, diacetone alcohol, terpineol, and benzyl alcohol.

In the Ag electrode paste according to the present invention, 13 to 17 weight % $SiO_2$ powders, 0 to 6 weight % $B_2O_3$ powders, 65 to 75 weight % $Bi_2O_3$ powders, 1 to 5 weight % $Al_2O_3$ powders, 1 to 3 weight % $TiO_2$ powders, and 0.5 to 2 weight % CuO powders are blended for use as the lead-free glass frits.

In the present invention, properties of the lead-free glass frits are not particularly limited, and frits having various properties such as spherical shape or crushed powder shape can be employed.

It is noted that the lead-free glass frit preferably has an average particle size (D50) in a range from 0.1 to 5 $\mu$m.

In addition, a ratio of blended lead-free glass frits is preferably in a range from 0.1 to 10 parts by weight with respect to 100 parts by weight Ag particles which are conductive powders. Further, from a point of view of avoiding peel-off of an electrode obtained by firing the Ag electrode paste at the interface and floating of glass or incomplete soldering, a ratio of blended lead-free glass frits is particularly preferably in a range from 1 to 5 parts by weight with respect to 100 parts by weight Ag particles.

Each component in the lead-free glass frits is limited as described above for the following reasons. The ratio of $SiO_2$ is set in a range from 13 to 17 weight %. When the ratio of $SiO_2$ is lower than 13 weight %, chemical durability of glass is lowered and moisture resistance as the Ag electrode also deteriorates. When the ratio of $SiO_2$ exceeds 17 weight %, a softening point of glass becomes excessively high, glass is likely to float at the surface of the Ag electrode, and solderability significantly deteriorates.

The ratio of $B_2O_3$ is set in a range from 0 to 6 weight %. When the ratio of $B_2O_3$ exceeds 6 weight %, a softening point of glass is lowered and wettability of glass to Ag becomes excessively high. Then, the glass tends to flow into the first electrode which is the electrode in the first layer and electrical contact between the first electrode and the semiconductor substrate is impeded.

When $B_2O_3$ is contained, stability as glass is improved, however, it is not necessarily required to contain $B_2O_3$ in the Ag electrode paste according to the present invention.

The ratio of $Bi_2O_3$ is set in a range from 65 to 75 weight %. When the ratio of $Bi_2O_3$ is lower than 65 weight %, a softening point of glass becomes higher, the glass tends to remain at the surface of the Ag electrode in a floating state, and solderability significantly deteriorates. When the ratio of $Bi_2O_3$ exceeds 75 weight %, a softening point of the glass is lowered, an amount of flow to the interface between the first electrode in the first layer and the semiconductor substrate increases, and electrical contact between the Ag electrode and the semiconductor substrate is impeded.

The ratio of $Al_2O_3$ is set in a range from 1 to 5 weight %. When the ratio of $Al_2O_3$ is lower than 1 weight %, crystallization of glass is likely which results in glass without flowability, and solderability of the second electrode in the second layer is lowered. When the ratio of $Al_2O_3$ exceeds 5 weight %, a softening point temperature of the glass is raised, and in this case as well, solderability of the second electrode in the upper layer side is lowered.

The ratio of $TiO_2$ is set in a range from 1 to 3 weight %. When the ratio of $TiO_2$ is lower than 1 weight %, stability of glass becomes poor. When the ratio of $TiO_2$ exceeds 3 weight %, crystallization of the glass is likely and flowability and stability of the glass are lowered. Namely, by setting the ratio of $TiO_2$ to 1 to 3 weight %, flowability of the glass and stability of the glass in a high temperature range can be ensured.

CuO has a function to enhance absorption of heat by glass itself and to achieve efficient heating during heating in a near-infrared furnace. When heat absorption by the glass itself is high, glass frits in irregular shape once become spherical and wettability to Ag powders becomes poor. Therefore a temperature at which sintering of the Ag electrode starts can be moved to a high temperature side. Consequently, occurrence of blister or the like caused by completion of sintering of the second electrode in the second layer before a decomposition gas or the like of a binder generated from the first electrode in the first layer completely escapes can be prevented.

The ratio of CuO is set in a range from 0.5 to 2 weight %. When the ratio of CuO is lower than 0.5 weight %, heat absorption efficiency of glass itself does not become so high. When the ratio of CuO exceeds 2 weight %, crystallization of the glass is likely, flowability of the glass is lowered, and solderability tends to deteriorate.

The Ag electrode paste according to the present invention can be manufactured, for example, by sufficiently mixing the Ag particles, the organic vehicle and the lead-free glass frits described above and thereafter further performing a kneading and mixing process using a triple roll mill followed by pressure reduction and degassing.

[Solar Battery Cell According to the Present Invention]

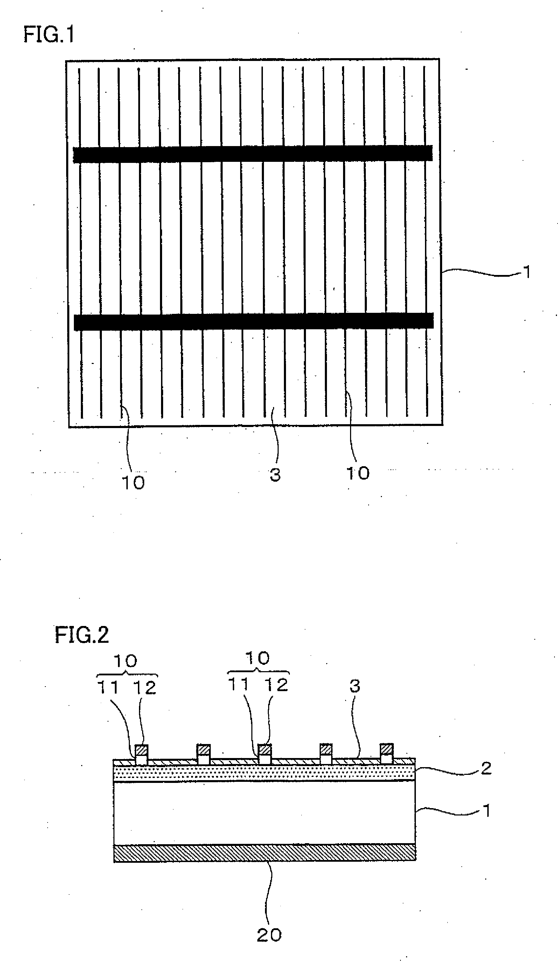

Fig. 1 is a plan view of a solar battery cell having a light-reception-surface-side electrode formed with the Ag electrode paste according to the present invention, and Fig. 2 is an enlarged view of a cross-section.

In this solar battery cell, a substrate (an Si semiconductor substrate) having an n-type impurity layer 2 to a depth of approximately 0.3 to 0.5 $\mu$m formed by diffusion of phosphorus on one main surface side of a p-type Si semiconductor substrate having a thickness of approximately 500 $\mu$m is used as a semiconductor substrate 1.

In addition, an anti-reflection coating 3 is formed on one surface of semiconductor substrate 1 (a surface where n-type impurity layer 2 is formed) functioning as a light reception surface. It is noted that a film made of such a material as SiNx, $SiO_2$, $TiO_2$, or the like is normally used as anti-reflection coating 3.

On the surface of semiconductor substrate 1 where anti-reflection coating 3 is formed (one main surface), a light-reception-surface-side electrode 10 for extracting a negative (minus) potential from n-type impurity layer 2 is formed.

Light-reception-surface-side electrode 10 includes a first electrode 11 which is an electrode on the lower layer side formed by applying and baking the Ag electrode paste and a second electrode 12 which is an electrode on the upper layer side formed by applying and baking the Ag electrode paste according to the present invention. First electrode 11 is formed to reach n-type impurity layer 2 through anti-reflection coating 3.

First electrode 11 on the lower layer side forming light-reception-surface-side electrode 10 mainly aims to ensure ohmic contact with semiconductor substrate 1, that is, to ensure electrical contact between the second electrode on the upper layer side forming light-reception-surface-side electrode 10 and semiconductor substrate 1.

In addition, second electrode 12 on the upper layer side forming light-reception-surface-side electrode 10 mainly aims to lower a line resistance of light-reception-surface-side electrode 10.

On the surface opposed to one surface of semiconductor substrate 1 (the other main surface), a back electrode 20 for extracting a positive (plus) potential from the other main surface side of semiconductor substrate 1 is formed.

Back electrode 20 is formed by applying and baking Al electrode paste containing Al powders as conductive components. It is noted that an electrode composed of Al and Ag, a part of which is implemented as an Ag electrode, may also be employed as back electrode 20.

First electrode 11 forming light-reception-surface-side electrode 10 is formed with the first Ag electrode paste containing Ag particles, lead-free glass frits composed as follows, and an organic vehicle,

<Composition of Lead-Free Glass Frits Contained in First Ag Electrode Paste>

21.2 weight % $SiO_2$
54.7 weight % $Bi_2O_3$
18.0 weight % BaO
6.1 weight % $B_2O_3$

This first Ag electrode paste can also be manufactured, for example, by sufficiently mixing the aforementioned Ag particles, the organic vehicle, the lead-free glass frits, and an oxide such as ZnO, $TiO_2$ or $ZrO_2$ having a function to remove the anti-reflection coating and thereafter further performing a kneading and mixing process using a triple roll mill followed by pressure reduction and degassing.

It is noted that paste containing 75 to 85 weight % Ag particles, 10 to 15 weight % organic vehicle, 1 to 4 weight % lead-free glass frits above, 2 to 6 weight % oxide such as ZnO, $TiO_2$ or $ZrO_2$ above may be used as the first Ag electrode paste in the present example.

Second electrode 12 forming light-reception-surface-side electrode 10 is formed with the second Ag electrode paste containing the Ag particles, the lead-free glass frits and the organic vehicle, and the Ag electrode paste according to the present invention manufactured as described above is used as this second Ag electrode paste.

Light-reception-surface-side electrode 10 is formed by printing the first Ag electrode paste and the second Ag electrode paste described above in a prescribed pattern with a screen printing method and thereafter simultaneously firing the pastes in a furnace. The first and second Ag electrode pastes are directly printed on anti-reflection coating 3 and then fired. Here, first electrode 11 on the lower layer side removes anti-reflection coating 3 and contact between first electrode 11 and (n-type impurity layer 2 of) semiconductor substrate 1 is ensured.

Meanwhile, since light-reception-surface-side electrode 10 is soldered during assembly of a module, second electrode 12 on the upper layer side forming light-reception-surface-side electrode 10 is required to have good solderability. In addition, since glass contained in second electrode 12 may flow toward first electrode 11 during firing, it is necessary not to impede contact between first electrode 11 and (n-type impurity layer 2 of) the semiconductor substrate. Here, by forming first electrode 11 and second electrode 12 with the first and second Ag electrode pastes described above, a highly reliable solar battery cell including the first and second electrodes capable of meeting the demands above can efficiently be manufactured.

Namely, as the lead-free glass frits contained in the second Ag electrode paste described above contain a proper amount of CuO, start of sintering of the electrode is effectively delayed. In addition, a proper amount of $Al_2O_3$ and $TiO_2$ is contained in glass, crystallization is less likely and moderate flowability is ensured. Therefore the glass moderately flows toward the first electrode side or the interface side between the first electrode and the semiconductor substrate during firing. Consequently, the glass is less likely to float at the surface of the second electrode and good solderability can be obtained. In addition, occurrence of blister due to sintering of the second electrode before a binder decomposition gas or the like completely escapes from the first electrode can be prevented.

In addition, the lead-free glass frits contained in the second Ag electrode paste do not impede ohmic contact between the Ag electrode in the first layer and the semiconductor substrate even though they flow into the Ag electrode in the first layer. Therefore conversion efficiency of a crystalline silicon solar battery cell is not lowered or blister or the like does not occur either.

Thus, by using the electrode paste according to the present invention as the Ag electrode paste for the second layer, a line resistance of the electrode can be lowered and increase in an interface resistance between the first electrode in the first layer and the semiconductor substrate can be prevented. Consequently, a solar battery cell achieving high conversion efficiency can be obtained.

Example 1

An example of the invention of the present application is shown below to describe the features of the invention of the present application in further detail.

<Preparation of Ag Electrode Paste>

The second Ag electrode paste for forming the second electrode was prepared by blending 100 parts by weight Ag particles, 2.5 parts by weight lead-free glass frits as shown in Table 1, 20 parts by weight organic vehicle obtained by dissolving ethyl cellulose in terpineol, sufficiently mixing these components, and thereafter further performing a kneading and mixing process using a triple roll mill followed by pressure reduction and degassing. It is noted that lead-free glass frits labeled as sample numbers 1 to 9 in Table 1 are lead-free glass frits satisfying the requirements of the present invention, and sample numbers 10 to 18 indicate lead-free glass frits in Comparative Examples not satisfying the requirements of the present invention.

Table I

| Sample No. | Lead-Free Glass Frit Composition (Weight %) | | | | | | | Light-Reception-Surface-Side Electrode Characteristic | | |
|---|---|---|---|---|---|---|---|---|---|---|
| | $SiO_2$ | $B_2O_3$ | $Bi_2O_3$ | $Al_2O_3$ | $TiO_2$ | CuO | Total | Solderability | Contact Resistance | Blister |
| 1 (Example 1) | 15.4 | 4.9 | 73.6 | 3.2 | 2.0 | 0.9 | 100.0 | ○ | ○ | No |
| 2 (Example 2) | 15.5 | 4.9 | 73.9 | 3.2 | 2.0 | 0.5 | 100.0 | ○ | ○ | No |
| 3 (Example 3) | 15.2 | 4.8 | 72.8 | 3.2 | 2.0 | 2.0 | 100.0 | ○ | ○ | No |
| 4 (Example 4) | 15.6 | 5.0 | 74.4 | 3.1 | 1.0 | 0.9 | 100.0 | ○ | ○ | No |
| 5 (Example 5) | 15.2 | 4.9 | 72.8 | 3.2 | 3.0 | 0.9 | 100.0 | ○ | ○ | No |
| 6 (Example 6) | 16.0 | 5.0 | 75.0 | 1.0 | 2.0 | 1.0 | 100.0 | ○ | ○ | No |
| 7 (Example 7) | 15.1 | 4.8 | 72.2 | 5.0 | 2.0 | 0.9 | 100.0 | ○ | ○ | No |
| 8 (Example 8) | 16.0 | 5.0 | 72.6 | 3.3 | 2.1 | 1.0 | 100.0 | ○ | ○ | No |
| 9 (Example 9) | 15.0 | 6.0 | 72.6 | 3.3 | 2.1 | 1.0 | 100.0 | ○ | ○ | No |
| 10 (Comparative Example 1) | 15.5 | 5.0 | 74.3 | 3.2 | 2.0 | 0.0 | 100.0 | ○ | ○ | Yes |
| 11 (Comparative Example 2) | 15.1 | 4.8 | 72.0 | 3.1 | 2.0 | 3.0 | 100.0 | × | ○ | No |
| 12 (Comparative Example 3) | 15.7 | 5.0 | 75.0 | 3.3 | 0.0 | 0.9 | 100.0 | × | ○ | No |
| 13 (Comparative Example 4) | 15.1 | 4.8 | 72.0 | 3.1 | 4.0 | 1.0 | 100.0 | × | ○ | No |
| 14 (Comparative Example 5) | 15.9 | 5.1 | 76.0 | 0.0 | 2.1 | 0.9 | 100.0 | × | ○ | No |
| 15 (Comparative Example 6) | 15.0 | 4.8 | 71.4 | 6.0 | 1.9 | 0.9 | 100.0 | × | ○ | No |
| 16 (Comparative Example 7) | 18.2 | 5.7 | 70.0 | 3.8 | 2.3 | 1.0 | 100.0 | × | ○ | No |
| 17 (Comparative Example 8) | 15.0 | 7.4 | 71.0 | 3.4 | 2.2 | 1.0 | 100.0 | ○ | × | No |
| 18 (Comparative Example 9) | 11.7 | 3.7 | 80.0 | 2.4 | 1.5 | 0.7 | 100.0 | ○ | × | No |

Ag electrode paste obtained by adding 2.5 weight % bismuth-barium-borosilicate-based glass frits, 5.0 weight % ZnO, and 20 weight % organic vehicle obtained by dissolving ethyl cellulose in terpineol to 100 weight % Ag powders was used as the first Ag electrode paste for forming first electrode 11 forming light-reception-surface-side electrode 10.

In this example, a solar battery cell including light-reception-surface-side electrode 10 having a two-layered structure of first electrode 11 and second electrode 12 shown in Figs. 1 and 2 was fabricated with the first and second Ag electrode pastes prepared as described above.

It is noted that a silicon substrate including an $SiN_x$ film as the anti-reflection coating was employed as semiconductor substrate 1.

In forming light-reception-surface-side electrode 10, first electrode 11 and second electrode 12 were formed by printing the Ag electrode paste for forming the first electrode in a prescribed pattern, printing the Ag electrode paste for forming the second electrode thereon in a prescribed pattern, and thereafter simultaneously firing the pastes at 750°C, so that light-reception-surface-side electrode 10 having a two-layered structure of first electrode 11 and second electrode 12 was formed.

Solderability, a contact resistance with semiconductor substrate 1, and whether blister occurred or not were examined for light-reception-surface-side electrode 10 of the solar battery cell fabricated as described above and the characteristics were evaluated. Table 1 shows the results together.

It is noted that a sample (a solar battery cell) labeled with each sample number in Table 1 is a sample of which second electrode 12 of light-reception-surface-side electrode 10 was formed with the second Ag electrode paste in which lead-free glass frits labeled with a corresponding sample number in Table 1 were blended, samples (solar battery cells) labeled with sample numbers 1 to 9 are solar battery cells satisfying the requirements of the present invention, and samples labeled with sample numbers 10 to 18 are solar battery cells in Comparative Examples not satisfying the requirements of the present invention.

In evaluating solderability, a sample labeled with each sample number was immersed in a solder bath set to 220°C for 2 seconds, and thereafter a surface immersed in solder was visually observed. A sample, 70% or more of which area was wet with solder, was evaluated as ○ (pass), and a sample, less than 70 % of which area was wet, was evaluated as × (fail).

In addition, in evaluating a contact resistance with semiconductor substrate 1, initially, a semiconductor substrate for evaluating a contact resistance having a light-reception-surface-side electrode formed by printing and firing Ag electrode paste for forming the first electrode and Ag electrode paste for forming the second electrode on the semiconductor substrate through the steps similar to those for a sample labeled with each sample number was prepared separately from each sample.

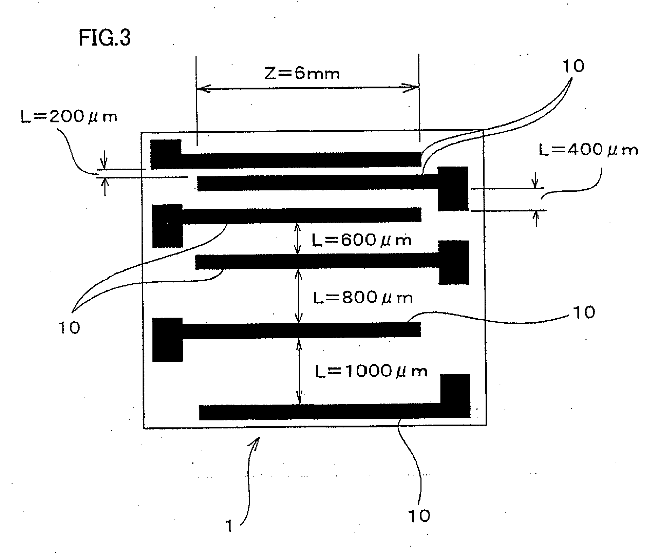

Fig. 3 is a diagram showing a structure of this sample (semiconductor substrate) for evaluating a contact resistance, and it has such a structure that a plurality of light-reception-surface-side electrodes 10 are arranged at prescribed intervals (a distance L between electrodes) as shown in Fig. 3 on the surface of substrate (semiconductor substrate) 1.

Thereafter, a contact resistance value was measured with a TLM method. Specifically, since relation as shown in Equation (1) below holds between distance L between electrodes and measured resistance value R, relation between distance L between electrodes and measured resistance value R was evaluated under various conditions and a contact resistance Rc was evaluated by extrapolating L to 0.

$$R = (L/Z) \times R_{SH} + 2Rc \qquad \ldots (1)$$

(Here, R represents a measured resistance value, L represents a distance between electrodes, $R_{SH}$ represents a sheet resistance of n-type Si, Z represents a length of a portion of adjacent light-reception-surface-side electrodes opposed to each other (a length of electrode), and Rc represents a contact resistance.)

As a result of evaluation above, a sample having contact resistance Rc not higher than 3 Ω was evaluated as ○ (pass), and a sample having a contact resistance exceeding 3 Ω was evaluated as × (fail).

In evaluating whether blister occurred or not, a sample labeled with each sample number was observed with an optical microscope to check whether blister occurred at the surface of light-reception-surface-side electrode 10 or not. A sample in which blister did not occur was evaluated as ○ (pass), and a sample in which blister occurred was evaluated as × (fail).

As shown in Table 1, it was confirmed that, in the case of the samples labeled with sample numbers 1 to 9 (that is, the solar battery cells in Examples 1 to 9 included in the technical scope of the present invention), the second Ag electrode paste, in which the lead-free glass frits labeled with sample numbers 1 to 9 were blended, was used for forming the second electrode forming the light-reception-surface-side electrode, and solderability was good, the contact resistance was low, and occurrence of blister was not observed.

In contrast, in the case of the sample labeled with sample number 10 (Comparative Example 1) including the lead-free glass frits not containing CuO, occurrence of blister was observed in the light-reception-surface-side electrode.

In addition, it was confirmed that, in the case of the sample labeled with sample number 11 (Comparative Example 2) including glass frits containing 3 weight % CuO, which is out of the range of the present invention (0.5 to 2 weight %), solderability of the light-reception-surface-side electrode was poor.

Moreover, it was confirmed that, in the case of the samples labeled with sample numbers 12 to 15 (Comparative Examples 3 to 6) including lead-free glass frits in which any of $Al_2O_3$ and $TiO_2$ forming the lead-free glass frits is out of the range of the present invention, crystallization of glass was likely in each case, the glass remained at the surface of the second electrode, and solderability lowered. In the case of the sample labeled with sample number 14 (Comparative Example 5), $Bi_2O_3$ was also out of the range of the present invention.

Further, it was confirmed that, in the case of the sample labeled with sample number 16 (Comparative Example 7) including lead-free glass frits of which content of $SiO_2$ was out of the range of the present invention, a softening point of glass was high, the glass remained at the surface of the second electrode, and solderability lowered.

Furthermore, it was confirmed that, in the case of the sample labeled with sample number 17 (Comparative Example 8) including lead-free glass frits of which content of $B_2O_3$ was out of the range of the present invention and the case of the sample labeled with sample number 18 (Comparative Example 9) including lead-free glass frits of which content of $Bi_2O_3$ was out of the range of the present invention, a softening point of glass was low, the glass flowed to the interface between the first electrode in the first layer and the semiconductor substrate, and the contact resistance was high. In the case of the sample labeled with sample number 18 (Comparative Example 9), $SiO_2$ was also out of the range of the present invention.

It was confirmed based on the results above that a highly reliable solar battery cell including a light-reception-surface-side electrode having good solderability, achieving a low contact resistance, and free from occurrence of blister can efficiently be manufactured with the use of the Ag electrode paste according to the invention of the present application.

The present invention is not limited to the examples above, and it is susceptible to various applications and modifications within the scope of the invention in connection with materials or configurations of a semiconductor substrate forming a solar battery cell, conditions for firing Ag electrode paste, compositions of lead-free glass frits, and the like.

INDUSTRIAL APPLICABILITY

As described above, according to the invention of the present application, a highly reliable solar battery cell including a light-reception-surface-side electrode having good solderability, achieving a low contact resistance, and free from occurrence of blister can efficiently be manufactured.

Therefore, the invention of the present application is widely applicable to a technical field relating to a solar battery cell manufactured through a process of forming a light-reception-surface-side electrode with a method of applying and baking conductive paste.

**Claims**

1. Ag electrode paste used for forming a light-reception-surface-side electrode of a solar battery cell, the solar battery cell including a semiconductor substrate, the light-reception-surface-side electrode arranged on one main surface functioning as a light reception surface out of a pair of main surfaces of said semiconductor substrate opposed to each other, and a back electrode arranged on the other main surface, comprising:

    (a) Ag particles;
    (b) an organic vehicle; and
    (c) lead-free glass frits containing 13 to 17 weight % $SiO_2$, 0 to 6 weight % $B_2O_3$, 65 to 75 weight % $Bi_2O_3$, 1 to 5 weight % $Al_2O_3$, 1 to 3 weight % $TiO_2$, and 0.5 to 2 weight % CuO, wherein

    when said light-reception-surface-side electrode includes a first electrode obtained by firing first Ag electrode paste and a second electrode obtained by firing second Ag electrode paste formed on the first electrode, said Ag electrode paste is used as said second Ag electrode paste.

2. A solar battery cell, comprising:

    a semiconductor substrate;
    a light-reception-surface-side electrode arranged on one main surface functioning as a light reception surface out of a pair of main surfaces of said semiconductor substrate opposed to each other; and

a back electrode arranged on the other main surface,

said light-reception-surface-side electrode including a first electrode obtained by firing first Ag electrode paste and a second electrode obtained by firing second Ag electrode paste formed on the first electrode, and the Ag electrode paste according to claim 1 being used as said second Ag electrode paste.

3. A method of manufacturing a solar battery cell including a semiconductor substrate, a light-reception-surface-side electrode arranged on one main surface functioning as a light reception surface out of a pair of main surfaces of said semiconductor substrate opposed to each other, and a back electrode arranged on the other main surface and having such a structure that said light-reception-surface-side electrode includes a first electrode obtained by firing first Ag electrode paste and a second electrode obtained by firing second Ag electrode paste formed on said first electrode, comprising the steps of:

forming an Ag electrode paste pattern for said first electrode by applying the first Ag electrode paste in a prescribed pattern onto said semiconductor substrate;
forming an Ag electrode paste pattern for said second electrode by applying the Ag electrode paste according to claim 1 in a prescribed pattern onto the Ag electrode paste pattern for said first electrode; and
simultaneously firing the Ag electrode paste pattern for said first electrode and the Ag electrode paste pattern for said second electrode.

**Patentansprüche**

1. Ag-Elektrodenpaste, welche zum Bilden einer lichtaufnahmeflächenseitigen Elektrode einer Solarbatteriezelle verwendet wird, wobei die Solarbatteriezelle umfasst: ein Halbleitersubstrat, die lichtaufnahmeflächenseitige Elektrode, die an einer als Lichtaufnahmefläche fungierenden Hauptfläche aus einem Paar von einander gegenüberliegenden Hauptflächen des Halbleitersubstrats angeordnet ist, und eine Rückelektrode, die an der anderen Hauptfläche angeordnet ist, umfassend:

(a) Ag-Partikel;
(b) einen organischen Träger; und
(c) bleifreie Glasfritten, die 13 bis 17 Gew.-% $SiO_2$, 0 bis 6 Gew.-% $B_2O_3$, 65 bis 75 Gew.-% $Bi_2O_3$, 1 bis 5 Gew.-% $Al_2O_3$, 1 bis 3 Gew.-% $TiO_2$ und 0,5 bis 2 Gew.-% CuO enthalten, wobei,

wenn die lichtaufnahmeflächenseitige Elektrode eine erste Elektrode, die durch Brennen einer ersten Ag-Elektrodenpaste erhalten wird, und eine zweite Elektrode, die durch Brennen einer auf der ersten Elektrode ausgebildeten zweiten Ag-Elektrodenpaste erhalten wird, umfasst, die Ag-Elektrodenpaste als die zweite Ag-Elektrodenpaste verwendet wird.

2. Solarbatteriezelle, umfassend:

ein Halbleitersubstrat;
eine lichtaufnahmeflächenseitige Elektrode, die an einer als Lichtaufnahmefläche fungierenden Hauptfläche aus einem Paar von einander gegenüberliegenden Hauptflächen des Halbleitersubstrats angeordnet ist; und
eine Rückelektrode, die an der anderen Hauptfläche angeordnet ist,

wobei die lichtaufnahmeflächenseitige Elektrode eine erste Elektrode, die durch Brennen einer ersten Ag-Elektrodenpaste erhalten wird, und eine zweite Elektrode, die durch Brennen einer auf der ersten Elektrode ausgebildeten zweiten Ag-Elektrodenpaste erhalten wird, umfasst und
wobei die Ag-Elektrodenpaste nach Anspruch 1 als die zweite Ag-Elektrodenpaste verwendet wird.

3. Verfahren zum Herstellen einer Solarbatteriezelle, welche umfasst: ein Halbleitersubstrat, eine lichtaufnahmeflächenseitige Elektrode, die an einer als Lichtaufnahmefläche fungierenden Hauptfläche aus einem Paar von einander gegenüberliegenden Hauptflächen des Halbleitersubstrat angeordnet ist, und eine Rückelektrode, die an der anderen Hauptfläche angeordnet ist und einen solchen Aufbau aufweist, dass die lichtaufnahmeflächenseitige Elektrode eine erste Elektrode, die durch Brennen einer ersten Ag-Elektrodenpaste erhalten wird, und eine zweite Elektrode, die durch Brennen einer auf der ersten Elektrode ausgebildeten zweiten Ag-Elektrodenpaste erhalten wird, umfasst, wobei das Verfahren die folgenden Schritte umfasst:

Ausbilden eines Ag-Elektrodenpastenmusters für die erste Elektrode durch Aufbringen der ersten Ag-Elektrodenpaste in einem festgelegten Muster auf das Halbleitersubstrat;
Ausbilden eines Ag-Elektrodenpastenmusters für die zweite Elektrode durch Aufbringen der Ag-Elektrodenpaste nach Anspruch 1 in einem festgelegten Muster auf das Ag-Elektrodenpastenmuster für die erste Elektrode; und
gleichzeitiges Brennen des Ag-Elektrodenpastenmusters für die erste Elektrode und des Ag-Elektrodenpastenmusters für die zweite Elektrode.

**Revendications**

1.  Pâte d'électrode à base d'Ag, utilisée pour former une électrode côté surface de réception de la lumière d'une cellule de batterie solaire, la cellule de batterie solaire comportant un substrat semi-conducteur, l'électrode côté surface de réception de la lumière agencée sur une surface principale fonctionnant comme surface de réception de la lumière d'une paire de surfaces principales dudit substrat semi-conducteur opposées l'une à l'autre, et une électrode arrière agencée sur l'autre surface principale, comprenant :

    (a) des particules d'Ag ;
    (b) un liant organique ; et
    (c) des frittes de verre sans plomb contenant 13 à 17 % en poids de $SiO_2$, 0 à 6 % en poids de $B_2O_3$, 65 à 75 % en poids de $Bi_2O_3$, 1 à 5 % en poids d'$Al_2O_3$, 1 à 3 % en poids de $TiO_2$, et 0,5 à 2 % en poids de CuO, dans lequel

    quand ladite électrode côté surface de réception de la lumière comporte une première électrode obtenue en cuisant une première pâte d'électrode à base d'Ag et une seconde électrode obtenue en cuisant une seconde pâte d'électrode à base d'Ag formée sur la première électrode, ladite pâte d'électrode à base d'Ag est utilisée comme ladite seconde pâte d'électrode à base d'Ag.

2.  Cellule de batterie solaire, comprenant :

    un substrat semi-conducteur ;
    une électrode côté surface de réception de la lumière agencée sur une surface principale fonctionnant comme surface de réception de la lumière d'une paire de surfaces principales dudit substrat semi-conducteur opposées l'une à l'autre ; et
    une électrode arrière agencée sur l'autre surface principale,

    ladite électrode côté surface de réception de la lumière comportant une première électrode obtenue en cuisant une première pâte d'électrode à base d'Ag et une seconde électrode obtenue en cuisant une seconde pâte d'électrode à base d'Ag formée sur la première électrode, et
    la pâte d'électrode à base d'Ag selon la revendication 1 étant utilisée comme ladite seconde pâte d'électrode à base d'Ag.

3.  Procédé de fabrication d'une cellule de batterie solaire comportant un substrat semi-conducteur, une électrode côté surface de réception de la lumière agencée sur une surface principale fonctionnant comme surface de réception de la lumière d'une paire de surfaces principales dudit substrat semi-conducteur opposées l'une à l'autre, et une électrode arrière agencée sur l'autre surface principale et présentant une structure telle que ladite électrode côté surface de réception de la lumière comporte une première électrode obtenue en cuisant une première pâte d'électrode à base d'Ag et une seconde électrode obtenue en cuisant une seconde pâte d'électrode à base d'Ag formée sur ladite première électrode, comprenant les étapes consistant à :

    former un motif de pâte d'électrode à base d'Ag pour ladite première électrode en appliquant la première pâte d'électrode à base d'Ag selon un motif prescrit sur ledit substrat semi-conducteur ;
    former un motif de pâte d'électrode à base d'Ag pour ladite seconde électrode en appliquant la pâte d'électrode à base d'Ag selon la revendication 1 selon un motif prescrit sur le motif de pâte d'électrode à base d'Ag pour ladite première électrode ; et
    cuire simultanément le motif de pâte d'électrode à base d'Ag pour ladite première électrode et le motif de pâte d'électrode à base d'Ag pour ladite seconde électrode.

FIG.1

FIG.2

FIG.3

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006339342 A
- JP 2006313744 A

- WO 2007102287 A1